# EUROPÄISCHE PATENTANMELDUNG

(11) **EP 0 940 720 A1**
(43) Veröffentlichungstag der Anmeldung: **08.09.1999**
(21) Anmeldenummer: 99102845.7
(22) Anmeldetag: 01.03.1999
(51) Int. Cl.: G03F 7/11, G03F 7/09, C09J 175/00, C09J 175/04, C08G 18/62

(54) **Photostrukturierbare Mehrschichtenelemente mit reversibel haftender Schutzfolie**

(30) Priorität: 05.03.1998 DE 19809494
(71) Anmelder: BASF Drucksysteme GmbH, 70469 Stuttgart (DE)
(72) Erfinder: Bronstert, Bernd, Dr., 67166 Otterstadt (DE); Zürger, Manfred, 74889 Sinsheim (DE); Hümmer, Wolfgang, Dr., 67134 Birkenheide (DE); Stebani, Uwe, Dr., 67592 Flörsheim-Dalsheim (DE)
(74) Vertreter: Isenbruck, Günter, Dr.

(57) **Zusammenfassung**

Die Erfindung betrifft ein photostrukturierbares Mehrschichtenelement, das zwischen einem Träger und einer abziehbaren Polymerfolie, vorzugsweise einer Polyesterfolie, eine photostrukturierbare Schicht aufweist, wobei das photostrukturierbare Element zwischen der Polymerfolie und der photostrukturierbaren Schicht eine der Polymerfolie unmittelbar benachbarte Haftschicht aufweist, die aus mindestens einer Polyisocyanatverbindung und 0 bis 1 Äquivalent, bezogen auf 1 Äquivalent Isocyanatgruppen, einer oder mehrerer Polyhydroxyverbindungen gebildet wird. Das photostrukturierbare Element kann zwischen der photostrukturierbaren Schicht und der Haftschicht eine polymere Deckschicht aus Polyvinylalkohol oder Polyamid aufweisen. Die Erfindung betrifft ferner Verfahren zur Herstellung eines solchen photostrukturierbaren Mehrschichtenelements sowie von mit der Haftschicht beschichteten Polymerfolien.

## Beschreibung

Die Erfindung betrifft photostrukturierbare Mehrschichtenelemente mit einer reversibel haftenden (abziehbaren) Schutzfolie, reversibel haftende Schutzfolien, Verfahren zu ihrer Herstellung sowie die Verwendung reversibel haftender Schutzfolien zur Herstellung der Mehrschichtenelemente.

Die Verwendung von Haftvermittlern oder Haftschichten zur Haftungsverbesserung von Polymerschichten in Mehrschichtenelementen, insbesondere bei der Herstellung von Relief- oder Druckformen, ist vielfach beschrieben worden. In den meisten Fällen dienen der Haftvermittler oder die Haftschicht zur Herstellung eines festen Verbundes zwischen Polymerschichten oder zwischen Polymerschichten und einem Schichtträger. Beispielsweise wird bei Hoch- oder Tiefdruckplatten üblicherweise die photostrukturierbare Schicht mittels einer Haftschicht und optional einer Oberlackschicht auf einem dimensionsstabilen Träger fixiert.

In der DE-A 30 45 516 ist ein Polyurethan-Haftlack aus einem Hydroxylgruppen enthaltenden Epoxidharz und einem Polyisocyanat offenbart, der auf einen Träger aufgebracht und, mit einer Oberlackschicht aus einem Polyamid und einem Melamin-Formaldehyd-Harz versehen, die permanente Haftung zu einer Photopolymerschicht aus einem Polyamid und einer ethylenisch ungesättigten Verbindung herstellt.

In vielen Fällen ist jedoch kein dauerhafter Verbund gewünscht. Insbesondere bei Druckplatten, die eine Folie zum Schutz gegen Verschmutzung und Beschädigung beim Transport aufweisen, ist eine reversible Haftung der Schutzfolie erforderlich. Die Haftung soll einerseits hoch genug sein, um ein unbeabsichtigtes Ablösen der Schutzfolie vor Ingebrauchnahme der Druckplatte zu vermeiden. Andererseits darf die Haftung nicht so hoch sein, daß beim wunschgemäßen Abziehen der Schutzfolie die darunterliegende Polymerschicht - die Photopolymerschicht oder eine auf der Photopolymerschicht befindliche Deckschicht - beschädigt wird.

Üblicherweise erfolgt eine Verbesserung der Adhäsions-Eigenschaften von Schutzfolien durch Corona-Behandlung. Dabei wird die Folie einer durch Corona-Entladung in einem elektrischen Wechselfeld ionisierten Atmosphäre ausgesetzt, wodurch die Oberflächeneigenschaften der Folie, insbesondere deren Haftung und Benetzbarkeit, modifiziert werden. Nachteilig an diesem Verfahren ist, daß die Adhäsions-Eigenschaften von coronabehandelten Folien nicht ausreichend stabil sind, was vermutlich auf eine Oberflächen-Reaktion mit Sauerstoff zurückzuführen ist. Ferner sind coronabehandelte Folien nicht ohne Verlust der Haftung wickelbar, wodurch eine Lagerhaltung im normalen Produktionsprozeß erschwert wird.

Aufgabe der Erfindung ist es, einen Haftvermittler für die reversible Verbindung einer Polymer-Schutzfolie mit der darunterliegenden Schicht eines Polymerverbundes, insbesondere bei Druckplatten mit einer unter der Schutzfolie liegenden Photopolymer- oder Deckschicht, bereitzustellen, der eine in einem weiten Bereich einstellbare Haftung ermöglicht und zeitlich konstante Haftungseigenschaften aufweist.

Gelöst wird die Aufgabe durch ein photostrukturierbares Mehrschichtenelement, das zwischen einem Träger T und einer abziehbaren Polymerfolie F eine photostrukturierbare Schicht P aufweist und das dadurch gekennzeichnet ist, daß das photostrukturierbare Mehrschichtenelement zwischen der Polymerfolie F und der photostrukturierbaren Schicht P eine der Polymerfolie F unmittelbar benachbarte Haftschicht H aufweist, wobei die Haftschicht H gebildet wird aus
h1) mindestens einer Isocyanatverbindung H1 und
h2) 0 bis 1 Äquivalent, bezogen auf die Isocyanatverbindung H1, einer oder mehrerer Hydroxyverbindungen H2.

Erfindungsgemäß wird auch eine mit einer solchen Haftschicht beschichteten Polymerfolie vorgeschlagen.

Die Haftschicht H kann als zusammenhängende Schicht oder in Form isolierter, inselartig verteilter Benetzungsstellen vorliegen.

Geeignete Träger T sind Metallbleche, beispielsweise aus Stahl, Aluminium, Kupfer oder Nickel, dimensionsstabile Polymerfolien, beispielsweise aus Polyethylenterephthalat, Polybutylenterephthalat, Polyamiden oder Polycarbonaten, ferner Gewebe und Vliese, wie Glasfasergewebe und -vliese, sowie Verbundmaterialien.

Geeignete Polymerfolien F sind Folien aus Polyvinylacetat, Polyethylen, Polypropylen, PVC und Polyester. Bevorzugte Polymerfolien sind Polyesterfolien, insbesondere solche aus gemischt aliphatisch-aromatischen Polyestern wie Polyethylenterephthalat (PET), Polybutylenterephthalat (PBT) und Polyethylen-2,6-naphthalindicarboxylat (PEN). Besonders bevorzugt sind Polymerfolien aus PET. Die Polymerfolien F weisen im allgemeinen eine Stärke von 6 bis 300, bevorzugt von 50 bis 250 , besonders bevorzugt von 75 bis 150 µm auf.

Zwischen dem Träger T und der Polymerfolie F weist das photostrukturierbare Mehrschichtenelement eine photostrukurierbare (lichtempfindliche) Schicht P auf. Die photostrukturierbare Schicht P kann direkt oder unter Zwischenschaltung einer Haftvermittlerschicht - beispielsweise wie in EP-B 0 055 807 beschrieben - auf dem Träger T aufgebracht sein. Die photostrukturierbare Schicht kann aus allen üblichen photostrukturierbaren Zusammensetzungen aufgebaut sein, d. h. Zusammensetzungen, die durch lichtinduzierten Molmassenaufbau, Molmassenabbau oder Furktionalitätswechsel eine Änderung ihrer Löslichkeit in einem Entwicklermedium erfahren. Es kommen sowohl in wäßrig oder wäßrig-alkoholischen Lösungsmitteln als auch in rein organischen Kohlenwasserstoff- oder Chlorkohlenwasserstoff-Lösungsmitteln entwickelbare, das heißt lösliche oder dispergierbare, Zusammensetzungen in Frage. Geeignete photostrukturierbare Zusammensetzungen sind in Ullmanns Encyclopedia of Technical Chemistry, Vol. A 13, Seite 613 - 615 und 631-632 beschrieben.

Bevorzugte photostrukturierbare Zusammensetzungen sind photovernetzbare oder photopolymerisierbare Zusammensetzungen aus einem elastomeren Bindemittel und mindestens einer damit verträglichen photovernetzbaren oder photopolymerisierbaren ethylenisch ungesättigten Verbindung. Geeignete ethylenisch ungesättigte Verbindungen sind beispielsweise mono- oder polyfunktionelle Acrylate, Methacrylate, Acrylamide und Methacrylamide, ferner Allylether, wie Polyurethane mit allylischen Endgruppen im Gemisch mit Mercaptanen, sowie N-Vinylverbindungen wie N-Vinylpyrrolidon. Geeignete Bindemittel sind zum Beispiel lösliche Polyamide, teilverseifte Polyvinylacetate, Celluloseester, Polyacrylate, Polyester oder Polyurethane, thermoplastische Elastomere wie Styrol-Isopren-Styrol-Dreiblock-Copolymerisate und Nitrilkautschuke. Die photovernetzbaren bzw. photopolymerisierbaren Zusammensetzungen können ferner übliche Photoinitiatoren wie Acyloine und aromatisch und aromatisch-aliphatische Ketone und Diketone, mehrkernige Chinone, Benzoylphosphine und Benzoylphosphinoxide, sowie übliche Additive wie Polymerisationsinhibitoren, Weichmacher, Farbstoffe und Sensibilisatoren enthalten. Geeignete photopolymerisierbare Zusammensetzungen sind beispielsweise in den EP-A 0 055 807, 0 059 988, 0 079 514, 0 224 164 und den DE-A 2 846 647 oder 3 045 516 beschrieben. Besonders bevorzugt sind dabei solche photopolymerisierbaren oder photovernetzbaren Zusammensetzungen, die in einem wäßrigen oder wäßrig-alkoholischen Entwickler löslich oder dispergierbar sind.

Zwischen der Polymerfolie F und der photostrukturierbaren Schicht P weisen die erfindungsgemäßen photostrukturierbaren Mehrschichtenelemente eine der Polymerfolie F benachbarte Haftschicht H auf. Die Haftschicht H wird gebildet aus
h1) mindestens einer Isocyanatverbindung H1 und
h2) 0 bis 1 Äquivalent, bezogen auf 1 Äquivalent Isocyanatgruppen von H1, einer oder mehrerer Hydroxyverbindungen H2.

Geeignete Isocyanatverbindungen H1 sind an sich bekannte aliphatische, cycloaliphatische und aromatische ein- oder mehrwertige Isocyanate.

Bevorzugt sind jedoch mehrwertige Isocyanate (Polyisocyanate), wie aliphatische, cycloaliphatische und aromatische mehrwertigen Isocyanate mit einem C₁- bis C₁₂-Kohlenwasserstoffrest. Bevorzugte Diisocyanate sind beispielsweise Alkylendiisocyanate mit 4 bis 12 Kohlenstoffatomen, wie 1,12-Dodecylendiisocyanat, 2-Ethyl-1,4-butylendiisocyanat, 2-Methyl-1,5-pentylendiisocyanat, 1,4-Butylendiisocyanat, 1,6-Hexamethylendiisocyanat (HDI); cycloaliphatische Diisocyanate, wie 1,3-Cyclohexylendiisocyanat, 1,4-Cyclohexylendiisocyanat, 1-Isocyanato-3,3,5-trimethyl-5-isocyanatomethylcyclohexan (Isophorondiisocyanat = IPDI), 2,4- und 2,6-Hexahydrotolylendiisocyanat und die entsprechenden Isomerengemische; 4,4'-, 2,2'- und 2,4'-Dicyclohexylmethandiisocyanat sowie die entsprechenden Isomerengemische und aromatische Diisocyanate wie 2,4- und 2,6-Tolylendiisocyanat (TDI) und deren Isomerengemische, 4,4'-, 2,2'- und 2,4'-Diphenylmethandiisocyanat (MDI) sowie deren Isomerengemische, Mischungen aus 4,4'-, 2,2'-Diphenylmethandiisocyanaten, Polyphenylpolymethylenpolyisocyanate (Polymer MDI), Mischungen aus 4,4'-, 2,2'- und 2,4'-Diphenylmethandiisocyanaten und Polyphenylpolymethylenpolyisocyanaten (Roh-MDI) und Mischungen aus Roh-MDI und Tolylendiisocyanaten. Besonders bevorzugt werden 1,6-Hexamethylendiisocyanat (HDI), 2,4- und 2,6-Tolylendiisocyanat (TDI) und deren Isomerengemische, Mischungen aus 4,4'-, 2,2'- Diphenylmethandiisocyanaten (MDI) und Polyphenylpolymethylenpolyisocyanate (Polymer MDI) verwendet.

Besonders bevorzugte Diisocyanate sind 2,4- und 2,6-Tolylendiisocyanat, Hexamethylendiisocyanat, Diphenylmethan-4,4'-diisocyanat und Isophorondiisocyanat.

Geeignete Hydroxyverbindungen H2 sind organische Mono- und Polyhydroxyverbindungen. Bevorzugt sind mehrwertige Hydroxyverbindungen (Polyhydroxyverbindungen) wie niedermolekulare Polyole, Polyesterpolyole, Polyetherpolyole und deren Copolymere sowie in seltenen Fällen Polyacrylatpolyole.

Geeignete niedermolekulare Polyole sind beispielsweise Glykole, Glycerin, 1,4-Butandiol, Trimethylolpropan, Sorbit, bevorzugt Ethylenglykol, Dipropylenglykol und Glycerin.

Polyesterpolyole können beispielsweise aus organischen Dicarbonsäuren mit 2 bis 12 Kohlenstoffatomen, vorzugsweise aliphatischen Dicarbonsäuren mit 4 bis 6 Kohlenstoffatomen, und mehrwertigen Alkoholen, bevorzugt Diolen mit 2 bis 12 Kohienstoffatomen, besonders bevorzugt mit 2 bis 6 Kohlenstoffatomen hergestellt werden.

Als Dicarbonsäuren können einzeln oder im Gemisch Bernsteinsäure, Glutarsäure, Adipinsäure, Korksäure, Azelainsäure, Sebacinsäure, Decandicarbonsäure, Maleinsäure, Fumarsäure, Phthalsäure, Isophthalsäure und Terephthalsäure verwendet werden. Bevorzugt verwendet man Dicarbonsäuregemische aus Bernsteinsäure, Glutarsäure und Adipinsäure. Statt freier Dicarbonsäuren können zur Herstellung der Polyester auch die entsprechenden Dicarbonsäureester, wie Dicarbonsäureester von Alkoholen mit 1 bis 4 Kohlenstoffatomen oder Dicarbonsäureanhydride, eingesetzt werden. Freie Dicarbonsäuren und Dicarbonsäureanhydride können außerdem im Gemisch mit Monocarbonsäuren, wie ungesättigte C₁₈- bis C₂₀-Fettsäuren, insbesondere Ölsäure verwendet werden.

Beispiele für zwei- oder mehrwertige Alkohole, insbesondere Diole, sind: Ethandiol, Diethylenglycol, 1,4-Butandiol, 1,5-Pentandiol, 1,6-Hexandiol, 1,10-Decandiol, Glycerin und Trimethylolpropan. Vorzugsweise werden 1,4-Butandiol, 1,5-Pentandiol, 1,6-Hexandiol und Trimethylolpropan verwendet.

Ferner werden Polyetherpolyole eingesetzt. Polyetherpolyole können nach dem Fachmann bekannten Verfahren, beispielsweise durch anionische Polymerisation von Epoxiden, wie Ethylenoxid oder Propylenoxid, mit Alkalihydroxiden, wie Natrium- oder Kaliumhydroxid oder Alkalialkoholaten, wie Natriummethylat, Natrium- oder Kaliumethylat oder Kaliumisopropylat, bevorzugt Natrium- oder Kaliumhydroxid als Katalysatoren und unter Zusatz mindestens eines Startermoleküls, das 2 bis 8, vorzugsweise 2 bis 4 reaktive Wasserstoffatome gebunden enthält, hergestellt werden. Als Startermoleküle kommen Wasser, Dicarbonsäuren wie Bernsteinsäure, Glutarsäure, Adipinsäure, Phthalsäure und Terephthalsäure, aliphatische und aromatische, gegebenenfalls dialkylsubstituierte Polyamine wie Ethylendiamin oder Diethylentriamin, bevorzugt Wasser, in Frage. Polyetherpolyole können auch durch kationische Polymerisation mit Lewissäuren, wie Antimonpentachlorid, Borfluorid-Etherat oder Bleicherde, als Katalysatoren aus Alkylenoxiden mit 2 bis 4 Kohlenstoffatomen hergestellt werden. Geeignete Alkylenoxide sind beispielsweise Tetrahydrofuran, 1,3-Propylenoxid, 1,2- bzw. 2,3-Butylenoxid, Styroloxid, vorzugsweise Ethylenoxid und Propylenoxid.

Als Startermoleküle werden außerdem vorzugsweise mehrwertige, insbesondere zwei- oder dreiwertige Alkohole, wie Ethandiol, Propan-1,2-diol, Diethylenglykol, Dipropylenglykol, Butan-1,4-diol, Hexan-1,6-diol, Glycerol, Trimethylolpropan, Pentaerythrit, Alkanolamine, wie Ethanolamin, N-Methyl- und N-Ethyldiethanolamin und Trialkanolamine eingesetzt. Besonders bevorzugt werden Diethylenglykol, Glycerin, Trimethylolpropan und Pentaerythrit eingesetzt.

Die hergestellten Polyole haben bevorzugt eine Funktionalität von 2 bis 8, besonders bevorzugt von 2 bis 5.

Die Isocyanatverbindungen H1 und die Hydroxyverbindungen H2 können in der Haftschicht als unumgesetzte Monomere oder auch zumindest teilweise als Umsetzungsprodukte vorliegen, wobei Umsetzungsprodukte sowohl die Reaktionsprodukte der Verbindungen H1 und H2 untereinander als auch Reaktionsprodukte mit in den angrenzenden Polymerschichten vorkommenden, mit H1 und gegebenenfalls H2 reaktionsfähigen Verbindungen sein können. Die Haftschicht H kann ausschließlich von Isocyanatverbindungen H1 oder aber von Isocyanatverbindungen H1 und Hydroxyverbindungen H2 gebildet werden, wobei die Hydroxyverbindungen H2 in Mengen von 0 bis 1 Äquivalent, das heißt maximal in stöchiometrischen Mengen bezüglich H1, vorliegen. Die Angaben von Äquivalenten bezieht sich auf die Zahl der in den Verbindungen H1 und H2 vorliegenden Isocyanat- bzw. Hydroxygruppen.

Das erfindungsgemäße photostrukturierbare Mehrschichtenelement kann zwischen der photostrukturierbaren Schicht P und der Polymerfolie F zusätzlich eine den Schichten P und F unmittelbar benachbarte polymere Deckschicht D aufweisen. Bei hoher Klebrigkeit der photostrukturierbaren Schicht wird durch die Deckschicht D eine Beschädigung der photostrukturierbaren Schicht beim Abziehen der Polyesterfolie vermieden. Auch wird durch die Deckschicht D vermieden, daß bei hoher Klebrigkeit der photostrukturierbaren Schicht beim Auflegen des photographischen Negatives die vorhandene Luft nicht gleichmäßig entfernt wird und es dadurch beim Belichten zu Vakuumfehlern kommt.

Geeignete polymere Deckschichten enthalten in einem für die Entwicklung der belichteten photopolymerisierbaren Schicht geeigneten Entwicklermedium lösliche oder dispergierbare Polymere. Geeignete lösliche oder dispergierbare Polymere sind Polyvinylalkohol und Polyamide. Vorzugsweise weist die polymere Deckschicht D, zumindest in der Grenzfläche mit der Haftschicht H, mit Isocyanatgruppen reaktionsfähige Gruppen wie Hydroxyl-, Amino- oder Amidgruppen auf. Bevorzugte Deckschichten D enthalten als Polymeres Polyvinylalkohol oder ein Polyamid wie Ultramid® 1C (BASF AG, Ludwigshafen, DE) oder Macromelt® 6900 (Henkel KGaA, Düsseldorf, DE). Bevorzugte Deckschichten sind beispielsweise die in DE-A 3 226 779 offenbarten Schichten aus Polyvinylalkohol mit einem Verseifungsgrad von mindestens 95 mol-%.

Im allgemeinen liegen die Hydroxyverbindungen H2 bezüglich der Isocyanatverbindungen H1 in unterstöchiometrischen Mengen vor. Es können auch die Isocyanatverbindungen H1 alleine vorliegen. Letzteres ist dann bevorzugt der Fall, wenn das photostrukturierbare Mehrschichtenelement eine polymere Deckschicht D aufweist.

In Fällen, in denen das photostrukturierbare Element keine polymere Deckschicht D aufweist, liegen die Hydroxyverbindungen H2 bevorzugt in Mengen von bis zu 80 Äquivalenten, besonders bevorzugt von bis zu 50 Äquivalenten, bezogen auf die Menge der Isocyanatverbindungen H1, vor.

Im allgemeinen umfaßt die Herstellung der photostrukturierbaren Mehrschichtenelemente folgende Schritte:
a) Auftragen einer Lösung, enthaltend in einem polaren Lösungsmittel, 0,0001 bis 1 Gew.-%
   h1) mindestens eine Isocyanatverbindung H1 und
   h2) 0 bis 1 Äquivalent, bezogen auf 1 Äquivalent Isocyanatgruppen von H1, eine oder mehrere Hydroxyverbindungen H2
   auf eine Polymerfolie F;
b) Trocknen,
c) Auftragen einer polymeren Deckschicht D auf die Haftschicht H,
d) Auftragen einer photostrukturierbaren Schicht P auf die Deckschicht D,
e) Verbinden der photostrukturierbaren Schicht P mit einem Träger T.

Schritt c) kann gegebenenfalls entfallen und die photostrukturierbare Schicht P direkt auf die Haftschicht H aufgetragen werden; Schritte d) und e) können auch gleichzeitig erfolgen.

In einem ersten Auftrageschritt (Schritt a) wird die Lösung, enthaltend die Isocyanatverbindungen H1 und gegebenenfalls die Hydroxyverbindungen H2, auf die Polymerfolie aufgetragen. Die Lösung enthält im allgemeinen 0,0001 bis 1 Gew.-%, bevorzugt 0,001 bis 1 Gew.-% der Isocyanatverbindung H1 bzw. der Isocyanatverbindung H1 und der Hydroxyverbindung H2. Als Lösungsmittel sind wasser- und alkoholfreie polare Lösungsmittel geeignet, beispielsweise Ester wie Ethylacetat, Etherester wie 1-Methoxypropylacetat, Ketone oder Aromaten wie Toluol und Xylol sowie deren Mischungen. Bevorzugte Lösungsmittel sind Ethylacetat, 2-Methoxypropylacetat und Xylol.

Das Auftragen dieser Lösung auf die Polymerfolie kann mit üblichen Auftrageverfahren wie Lackieren, Gießen, Aufsprühen oder Tauchen, durch Walzenauftrag oder Rakeln erfolgen. Bevorzugt wird die Lösung im sogenannten Kisscoating-Verfahren durch eine gegen die Folienbahn laufende Auftragswalze gegen die Folie angetragen. Im allgemeinen beträgt die Auftragsdicke (naß) der Schicht 1 bis 50 , bevorzugt 2 bis 20 µm.

An den ersten Auftrageschritt schließt sich ein erster Trocknungsschritt (Schritt b) an. Der Trocknungschritt wird bei 20 bis 110°C, bevorzugt 40 bis 100°C, besonders bevorzugt 50 bis 90°C während einer Zeitdauer von 0,5 bis 20, bevorzugt 1 bis 10, besonders bevorzugt 2 bis 5 min durchgeführt. Bei dem Trocknungsschritt verdampft zumindest st ein Teil des Lösungsmittels, ferner kann zumindest teilweise Polykondensation zwischen den Verbindungen H1 und H2 bzw. den Verbindungen H1 und H2 und den Verbindungen der angrenzenden Polymerschichten stattfinden. Nach Durchführung des Trocknungsschrittes ist die mit der Haftschicht H beschichtete Polymerfolie wickelbar und kann zwischengelagert werden.

Es kann sich ein weiterer Auftrageschritt (Schritt c) anschließen, in dem auf die Haftschicht H die Deckschicht D aufgetragen wird. Es kommen die vorstehend genannten Auftrageverfahren in Frage. Die Deckschicht D kann als Schmelze oder aus Lösung aufgebracht werden. Im allgemeinen beträgt die Auftragsdicke (naß) der Deckschicht D 1 bis 100, bevorzugt 10 bis 50 µm. Es kann sich ein weiterer Trocknungsschritt anschließen.

In einem weiteren Auftrageschritt (Schritt d) wird die photostrukturierbare Schicht P auf die Haftschicht H bzw. auf die flüssige oder getrocknete Deckschicht D aufgetragen. Die photostrukturierbare Schicht P kann als Schmelze oder aus Lösung aufgetragen werden. Es können die vorstehend genannten Auftrageverfahren angewendet werden. Es kann sich ein weiterer Trocknungsschritt anschließen. Es können auch mehrere photostrukturierbare (Teil)Schichten P', P'' usw. unterschiedlicher Zusammensetzung, die gemeinsam die photostrukturierbare Schicht P bilden, aufgetragen werden, wobei sich nach dem Auftragen einer oder mehrerer Schichten jeweils ein Trocknungsschritt anschließen kann. Die mit der Haftschicht H, gegebenenfalls einer Deckschicht D und mit der Photopolymerschicht P beschichteten Polymerfolie F kann aufgewickelt und zwischengelagert werden.

Schließlich wird in einem Verbindungsschritt (Schritt e) die photostrukturierbare Schicht P mit dem Träger T verbunden. Dazu kann der Träger T eine übliche Haftvermittlerschicht aufweisen. Das Verbinden kann nach üblichen Verfahren zur Herstellung von Laminaten, beispielsweise durch Aufkaschieren des Trägers T auf die photostrukturierbare Schicht B, erfolgen.

Schritte d) und e) können auch gleichzeitig erfolgen, zun Beispiel in der Weise, daß die photostrukturierbare Schicht P als extrudierbare Masse zwischen die mit der Haftschicht H und gegebenenfalls der getrockneten Deckschicht D beschichteten Polymerfolie und dem Träger T extrudiert wird.

In einer bevorzugten Ausführungsform erfolgt die Herstellung der Mehrschichtenelemente durch Auftragen der Haftschicht H auf die Polymerfolie F, Trocknen, gegebenenfalls Auftragen der Deckschicht D auf die Haftschicht H, Auftragen einer photostrukturierbaren Schicht P auf die Deckschicht D oder auf die Haftschicht H, Trocknen und Aufkaschieren des Trägers T auf die photostrukturierbare Schicht P.

In einer weiteren bevorzugten Ausführungsform erfolgt die Herstellung der Mehrschichtenelemente durch Auftragen der Haftschicht H auf die Polymerfolie F, Trocknen, gegebenenfalls Auftragen der Deckschicht D auf die Haftschicht H, Trocknen und Extrudieren einer photostrukturierbaren Schicht P zwischen die Deckschicht D und den Träger T beziehungsweise zwischen die Haftschicht H und den Träger T.

Gegenstand der Erfindung ist auch ein Verfahren zur Herstellung einer mit einer Haftschicht beschichteten Polymerfolie mit den Schritten:
a) Auftragen einer Lösung, enthaltend in einem polaren Lösungsmittel, 0,0001 bis 1 Gew.-%
   h1) mindestens eine Isocyanatverbindung H1 und
   h2) 0 bis 1 Äquivalent, bezogen auf 1 Äquivalent Isocyanatgruppen von H1, einer oder mehrerer Hydroxyverbindung H2
      auf eine Polymerfolie F;
b) Trocknen.

Das Aufbringen einer Deckschicht D kann gegebenenfalls entfallen.

Gegenstand der Erfindung ist daher auch ein Verfahren zur Herstellung eines photostrukturierbaren Mehrschichtenelements mit den Schritten:
i) Herstellen einer mit einer Haftschicht beschichteten Polymerfolie gemäß dem vorstehend genannten Verfahren
ii) Auftragen einer photostrukturierten Schicht P auf die Haftschicht H und
iii) Verbinden der photostrukturierbaren Schicht P mit einem Träger T, wobei die Schritte ii) und iii) auf gleichzeitig erfolgen können.

Durch Wahl der Verdünnung der die Verbindungen H1 und gegebenenfalls H2 enthaltenden Lösung läßt sich die Haftung der Polymerfolie gezielt einstellen. Es wird vermutet, daß die haftungsvermittelnde Wirkung der Haftschicht H auf in der Grenzfläche mit der Polymerfolie vorhandenen freien NCO-Gruppen beruht. Gemäß einer Modellvorstellung liegt bei Anwendung einer stark verdünnten Lösung der Verbindungen H1 und gegebenenfalls H2 die Haftschicht H nach dem Trocknungsschritt nicht als zusammenhängende Schicht vor, sondern in Form isolierter, inselartig verteilter Benetzungsstellen. Die Haftung der Polymerfolie wird dieser Vorstellung zufolge auch durch die Anzahl der vorhandenen Benetzungsstellen bestimmt, die umso größer ist, je konzentrierter die aufgetragene Lösung der Verbindungen H1 und gegebenenfalls H2 ist. Eine gezielte Einstellung der Haftung läßt sich darüber hinaus auch durch Wahl des Verhältnisses der Komponente H1 zu der Komponente H2 erreichen, da dieses Verhältnis einen Einfluß auf die Zahl der nach der Kondensation vorhandenen freien NCO-Gruppen hat.

Die Einstellung einer definierten Haftung durch gezieltes Verdünnen der Verbindungen H1 und H2 und Wahl ihres Mengenverhältnisses ist ein allgemein anwendbares Prinzip und nicht auf Schutzfolien für Druckplatten beschränkt.

Die Haftung kann so eingestellt werden, daß ein unbeabsichtigtes, vorzeitiges Ablösen der Polymerfolie vermieden wird, andererseits ein Abziehen der Polymerfolie ohne hohen Kraftaufwand und ohne Beschädigung der unterhalb der Haftschicht liegenden Polymerschicht möglich ist.

Die Verwendung der erfindungsgemäßen, mit einer Haftschicht versehenen Polymerfolie zur Herstellung von Druckplatten bringt ferner weitere Vorteile mit sich.

So weist nach dem Abziehen der Polymerfolie die darunter liegende Oberfläche keine höhere Klebrigkeit auf als die entsprechende Oberfläche einer Druckplatte mit abziehbarer Polymerfolie ohne Haftschicht. Durch die geringe Klebrigkeit der Oberfläche wird gewährleistet, daß beim Auflegen des Negativs die Luft gleichmäßig entweichen kann.

Auch behält die mit der Haftschicht beschichtete Polymerfolie ihre Haftungseigenschaften auf Dauer bei. Die beschichtete Polymerfolie ist außerdem aufwickelbar und kann somit zwischengelagert werden.

Die Haftung einer Polyesterfolie auf einer Zwischenschicht aus Polyvinylalkohol bzw. aus Polyamid beträgt im allgemeinen 2 bis 50 cN/cm, bevorzugt 4 bis 30 cN/cm, besonders bevorzugt 5 bis 25 cN/cm. Die Haftung kann so eingestellt werden, daß der Verbund aus Polyesterfolie, Haftschicht, Deckschicht, Photopolymerschicht und Träger in Formate geschnitten werden kann, ohne daß es zur Ablösung der Polyesterfolie kommt.

Die Haftung wird auf einer Zugprüfmaschine an 4 cm breiten Streifen des Polymerverbundes als die Kraft bestimmt, die zum Abziehen der Polyesterfolie mit einer Geschwindigkeit von 60 mm/min senkrecht zur Oberfläche des Polymerverbundes erforderlich ist.

Die Erfindung wird durch die nachstehenden Beispiele näher erläutert.

### Beispiel 1:

Eine 125 µm dicke Folie aus Polyethylenterephthalat (Lumirror® X 43, 125 µm der Toray Industries Inc., Tokyo) wird mit einer Lösung, enthaltend 0,015 Gew.-% eines Gemisches von 2,4- und 2,6-Tolylendiisocyant in einer 1:1-Mischung von 2-Methoxypropylacetat und Xylol als Verdünnungsmittel (Desmodur® L 67 der Bayer AG, Leverkusen, gelöst in SV 41 0381 20 der Bayer AG, Leverkusen, DE) im Kisscoating-Verfahren beschichtet. Unter den eingestellten Bedingungen ergibt sich eine Auftragsdicke (naß) von 13 µm. Anschließend wird im Umlufttrockenschrank bei 75 °C über einen Zeitraum von 3 min getrocknet. Die Trockendicke der Haftschicht beträgt danach ca. 0,2 µm. Die beschichtete Folie wird aufgewickelt und über einen Zeitraum von 4 Tagen gelagert. In weiteren Beschichtungsschritten wird auf die Folie zunächst eine Polyvinylalkohol-Lösung (2,2 Gew.-% in Wasser/Propanol 4:1) als Deckschicht und anschließend eine Photopolymerlösung aus 120 Gewichtsteilen eines nachträglich polymeranalog acrylierten Polyvinylalko-hols, wie er in der EP-A 0 079 514 beschrieben ist, 180 Gewichtsteilen eines Copolymeren aus Vinylalkohol und Ethylenoxid, wie es in der DE-A 2 846 647 beschrieben ist und 340 Gewichtsteilen einer ethylenisch ungesättigten Verbindung (Phenylglycidetheracrylat, Laromer® 8830 der BASF AG, Ludwigshafen, DE), 3 Gewichtsteilen eines Photoinitiators (Benzildimethylketal, Irgacure® 651 der Ciba-Geigy, Basel, CH) und einen Gewichtsteil eines Farbstoffes, gelöst in einem Gemisch aus 600 Gewichtsteilen Wasser und 600 Gewichtsteilen n-Propanol, aufgetragen und 60 min bei 80°C getrocknet. Der so hergestellte Verbund aus Polyesterfolie, Haftschicht, Deckschicht und Photopolymerschicht wird mit der Photopolymerschicht-Seite auf den Träger, ein mit einem Haftvermittler beschichtetes Stahlblech, aufkaschiert.

Der so hergestellte Verbund kann anschließend in Formate geschnitten werden, ohne daß sich die Polyester-Schutzfolie ablöst.

Zur Bestimmung der Haftung der Polyesterfolie wird der Verbund in 4 cm breite Streifen geschnitten und auf einer Zugprüfmaschine die Polyesterfolie mit einer Geschwindigkeit von 60 mm/min senkrecht zur Oberfläche des Verbunds abgezogen. Es wird ein Haftwert von 80 cN/4cm ermittelt. Beim Abziehen verbleibt die Deckschicht unbeschädigt auf der Photopolymerschicht.

Außerdem wird nach Abziehen der Polyesterfolie die Pendelklebrigkeit der darunter liegenden Oberfläche bestimmt. Die Bestimmung der Pendelklebrigkeit geschieht auf einem Prüfgerät der Erichsen GmbH, Modell 299/300. Je klebriger die betreffende Oberfläche ist, desto stärker werden die Schwingungen des Pendels gedämpft und um so geringere Pendelklebrigkeitswerte werden erhalten (Referenzwert: 435 Pendelausschläge für eine Glasoberfläche). Es wird ein Wert von 30 Pendelausschlägen ermittelt.

### Beispiel 2:

Eine 125 µm dicke Folie aus Polyethylenterephthalat (Lumirror® X 43 der Toray Industries Inc., Tokyo) wird mit der in Beispiel 1 beschriebenen Lösung, aber mit 0,1 Gew.-% Diisocyanat im Kisscoating-Verfahren beschichtet, wobei sich eine Auftragsdicke (naß) von 13 µm ergibt. Anschließend wird im Umlufttrockenschrank bei 75 °C über einen Zeitraum von 3 min getrocknet. Die Trockendicke der Haftschicht betragt ca. 0,1 µm. Die beschichtete Folie wird aufgewickelt und über einen Zeitraum von 4 Tagen gelagert. Anschließend wird in einem weiteren Beschichtungsschritt auf die Haftschicht eine Polyamid-Lösung (6 Gew.-% Macromelt® 6900 in Propanol/Toluol 1:1) als Deckschicht aufgetragen und bei 75°C über einen Zeitraum von 4 min getrocknet. Zwischen die mit der Haftschicht und der Deckschicht aus Polyamid beschichtete Polyester-Schutzfolie und eine mit einem Haftvermittler beschichtete Polyester-Trägerfolie wird eine Photopolymermischung aus 785 Gewichtsteilen eines thermoplastischen elastomeren Styrol-Isopren-Styrol-Dreiblock-Copolymerisats (Cariflex® TR 1107 der SHELL, DE), 50 Gewichtsteile einer zweifach ethylenisch ungesättigten Verbindung (Hexandioldiacrylat), 12 Gewichtsteilen eines Photoinitiators (Benzildimethylketal, Irgacure® der Ciba-Geigy, Basel, CH), 12 Gewichtsteilen eines Stabilisators (Kerobit® TBK der BASF AG, Ludwigshafen, DE), 0,02 Gewichtsteilen eines Farbstoffs (Sudan Rot 380) und 130 Gewichtsteilen eines Paraffinöls als Weichmacher, extrudiert.

Der so hergestellte Verbund kann anschließend in Formate geschnitten werden, ohne daß sich die Polyester-Schutzfolie ablöst.

Der Verbund wird in 4 cm breite Streiten geschnitten und die Haftung der Polyester-Schutzfolie, wie obenstehend beschrieben, bestimmt. Es wird ein Haftwert von 32 cN/4cm ermittelt. Beim Abziehen verbleibt die Trennschicht unbeschädigt auf der Photopolymerschicht.

Die Bestimmung der Pendelklebrigkeit ergibt einen Wert von 65 Pendelausschlägen.

### Beispiel 3:

Eine 125 µm dicke Folie aus Polyethylenterephthalat (Lumirror® X 43 der Toray Industries Inc., Tokyo/JP) wird mit einer Lösung des in Beispiel 1 beschriebenen Diisocyanats von 0,1 Gew.-% im Kisscoating-Verfahren beschichtet, wobei sich eine Auftragsdicke (naß) von 13 µm ergibt. Anschließend wird im Umlufttrockenschrank bei 75°C über einen Zeitraum von 3 min getrocknet. Die Trockendicke der Haftschicht beträgt ca. 0,1 µm. Die beschichtete Folie wird aufgewickelt und über einen Zeitraum von 4 Tagen gelagert. In einem weiteren Beschichtungsschritt wird eine Photopolymerlösung aus 100 Gewichtsteilen eines nachträglich polymeranalog acrylierten Polyvinylalkohols, wie er in der EP-A 0 079 514 beschrieben ist, 150 Gewichtsteilen eines teilhydrolysierten Polyvinylalkohols (Poval® KP 405 der Kuraray Japan) und 155 Gewichtsteilen einer ethylenisch ungesättigten Verbindung, (1,2,3-Tris(methacrylamidomethoxy)propan), 3 Gewichtsteilen eines Photoinitiators, 1 Gewichtsteil eines Farbstoffes, gelöst in einem Gemisch aus 750 Gewichtsteilen Wasser und 250 Gewichtsteilen n-Propanol, aufgetragen und 60 min bei 80°C getrocknet. Der so hergestellte Verbund aus Polyesterfolie, Haftschicht und Photopolymerschicht wird mit der Photopolymerseite auf den Träger, ein mit einem Haftvermittler beschichtetes Stahlblech, aufkaschiert.

Der so hergestellte Verbund kann anschließend in Formate geschnitten werden, ohne daß sich die Polyester-Schutzfolie ablöst.

Der Verbund wird in 4 cm breite Streifen geschnitten und die Haftung der Polyester-Schutzfolie, wie oben beschrieben, bestimmt. Es wird ein Haftwert von 23 cN/4cm ermittelt.

Die Bestimmung der Pendelklebrigkeit ergibt einen Wert von 28 Pendelausschlägen.

### Vergleichsbeispiel 1:

Eine Polyesterfolie wird einer Corona-Vorbehandlung unterzogen. Anschließend wird ein Polymerverbund analog Beispiel 1 hergestellt, wobei auf die Haftschicht zwischen Polyesterfolie und Deckschicht verzichtet wird.

Der Verbund läßt sich nicht ohne Ablösung der Polyesterfolie in Formate schneiden.

Für die Haftung wird ein Wert von 10 cN/2cm ermittelt.

Für die Pendelklebrigkeit wird ein Wert von 30 Pendelausschlägen ermittelt. Dies entspricht dem Wert für die Pendelklebrigkeit aus Beispiel 1.

## Patentansprüche

1. Photostrukturierbares Mehrschichtenelement, das zwischen einem Träger T und einer abziehbaren Polymerfolie F eine photostrukturierbare Schicht P aufweist, dadurch gekennzeichnet, daß das photostrukturierbare Element zwischen der Polymerfolie F und der photostrukturierbaren Schicht P eine der Polymerfolie F unmittelbar benachbarte Haftschicht H aufweist, wobei die Haftschicht H gebildet wird aus
h1) mindestens einer Isocyanatverbindung H1 und
h2) 0 bis 1 Äquivalent, bezogen auf 1 Äquivalent Isocyanatgruppen von H1, einer oder mehrerer Hydroxyverbindungen H2.

2. Photostrukturierbares Mehrschichtenelement nach Anspruch 1, dadurch gekennzeichnet, daß es zwischen der photostrukturierbaren Schicht P und der Haftschicht H zusätzlich eine der photostrukturierbaren Schicht P und der Haftschicht H unmittelbar benachbarte polymere Deckschicht D aufweist.

3. Photostrukturierbares Mehrschichtenelement nach Anspruch 1 oder 2, dadurch gekennzeichnet, daß die Isocyanatverbindung H1 eine Polyisocyanatverbindung und die Hydroxyverbindungen H2 eine Polyhydroxyverbindung ist.

4. Photostrukturierbares Mehrschichtenelement nach einem der Ansprüche 1 bis 3, dadurch gekennzeichnet, daß die Polymerfolie F eine Polyesterfolie ist.

5. Photostrukturierbares Mehrschichtenelement nach einem der Ansprüche 2 bis 4, dadurch gekennzeichnet, daß die polymere Deckschicht D als Polymeres Polyvinylalkohol oder ein Polyamid enthält.

6. Verfahren zur Herstellung einer mit einer Haftschicht beschichteten Polymerfolie mit den Schritten:
a) Auftragen einer Lösung, enthaltend in einem polaren Lösungsmittel, 0,0001 bis 1 Gew.-%
h1) mindestens eine Isocyanatverbindung H1 und
h2) 0 bis 1 Äquivalent, bezogen auf 1 Äquivalent Isocyanatgruppen von H1, einer oder mehrerer Hydroxyverbindung H2
auf eine Polymerfolie F;
b) Trocknen.

7. Verfahren zur Herstellung eines photostrukturierbaren Mehrschichtenelements mit den Schritten:
a) Auftragen einer Lösung, enthaltend in einem polaren Lösungsmittel, 0,0001 bis 1 Gew.-%
h1) mindestens eine Isocyanatverbindung H1 und
h2) 0 bis 1 Äquivalent, bezogen auf 1 Äquivalent Isocyanatgruppen von H1, einer oder mehrerer Hydroxyverbindung H2
auf eine Polymerfolie F;
b) Trocknen;
c) Auftragen einer polymeren Deckschicht D auf die Haftschicht H;
d) Auftragen einer photostrukturierbaren Schicht P auf die Deckschicht D und
e) Verbinden der photostrukturierbaren Schicht P mit einem Träger T,
wobei die Schritte d) und e) auch gleichzeitig erfolgen können.

8. Verfahren zur Herstellung eines photostruktierbaren Mehrschichtenelements mit den Schritten:
i) Herstellen einer mit einer Haftschicht beschichteten Polymerfolie gemäß dem Verfahren nach Anspruch 6,
ii) Auftragen einer photostrukturierbaren Schicht P auf die Haftschicht H und
iii) Verbinden der photostrukturierbaren Schicht P mit einem Träger T, wobei die Schritte ii) und iii) auf gleichzeitig erfolgen können.

9. Verwendung einer mit einer Haftschicht beschichteten Polymerfolie, wobei die Haftschicht gebildet wird aus
h1) mindestens einer Isocyanatverbindung H1 und
h2) 0 bis 1 Äquivalent, bezogen auf 1 Äquivalent Isocyanatgruppen von H1, einer oder mehrerer Hydroxyverbindungen H2
zur Herstellung eines photostrukturierbaren Mehrschichtenelements.
